# EUROPEAN PATENT APPLICATION

(11) **EP 4 755 974 A1**
(43) Date of publication of application: **10.06.2026**
(21) Application number: 24849120.1
(22) Date of filing: 29.07.2024
(51) Int. Cl.: C08L 101/00, B32B 27/20, B32B 27/30, C08J 5/24, C08K 5/54, C08K 9/06, C08L 33/04, C08L 63/00, C08L 83/04, H01L 23/14, H05K 1/03

(54) **RESIN COMPOSITION, PREPREG, LAMINATED PLATE, METAL-CLAD LAMINATED PLATE, PRINTED WIRING BOARD, AND SEMICONDUCTOR PACKAGE**

(30) Priority: 02.08.2023 JP 2023126243
(71) Applicant: Resonac Corporation, Tokyo 105-7325 (JP)
(72) Inventor: SUTOU, Kyousuke, Tokyo 105-7325 (JP); SAKAMOTO, Norihiko, Tokyo 105-7325 (JP); SUNAIRI, Yoshiya, Tokyo 105-7325 (JP); SHIMAOKA, Shinji, Tokyo 105-7325 (JP)
(74) Representative: Hoffmann Eitle
(86) International application number: PCT/JP2024/026913
(87) International publication number: WO 2025/028469

(57) **Abstract**

Provided is a resin composition containing an acrylic polymer serving as a combustible component, the resin composition having excellent flame resistance with satisfactory adhesion strength to a copper foil and desmear resistance maintained. Further, a prepreg, a laminated plate, a metal-clad laminated plate, a printed wiring board, and a semiconductor package that are produced using the resin composition are provided. The resin composition is specifically a resin composition containing an acrylic polymer (A), a thermosetting resin (B), and an inorganic filler (C) surface-treated with a silane coupling agent, further containing a silane coupling agent (D).

## Description

### Technical Field

The present disclosure relates to a resin composition, a prepreg, a laminated plate, a metal-clad laminated plate, a printed wiring board, and a semiconductor package.

### Background Art

Heretofore, halogen-based flame retardants containing a halogen, such as bromine, have been used as a flame retardant of a resin composition used in electronic parts, such as a printed wiring board and a semiconductor sealing material. However, in recent years, introduction of a halogen-free product using no conventional bromine-based flame retardant containing a halogen has been advanced in consideration of environmental issues. The term "halogen-free" means that no halogen atoms are contained at all or the content of a halogen atom is very small. For example, Japan Electronics Packaging and Circuits Association specifies that a copper-clad laminated plate for halogen-free printed wiring board contains chlorine (Cl) and bromine (Br) at each content ratio of 900 ppm or less and the total content ratio thereof is 1,500 ppm or less.

Accordingly, for example, flame retardants containing no halogen including phosphorus-based flame retardants, such as a phosphazene compound, a phosphoric acid ester compound, and a phosphoric acid ester amide compound, have been currently proposed as a flame retardant instead of a halogen-containing compound (see, for example, PTL 1).

### Citation List

### Patent Literature

PTL 1: JP 2023-040078 A, paragraph [0077]

### Summary of Invention

### Technical Problem

However, when a phosphorus-based flame retardant is incorporated into a resin composition, flame resistance is enhanced, whereas properties required for application of a printed wiring board and application of a semiconductor package, such as adhesion strength to a copper foil and desmear resistance, tend to decrease. In recent years, a relatively combustible component, such as an acrylic polymer, may be used from the viewpoint of dielectric properties (dielectric constant and dielectric loss tangent), flexibility, or the like. In this case, an improvement in flame resistance is required, but a large amount of phosphorus-based flame retardant cannot be blended due to the tendency.

Accordingly, there is a strong demand for the development of a resin composition containing an acrylic polymer serving as a combustible component, the resin composition containing a component that can maintain adhesion strength to a copper foil and desmear resistance with flame resistance improved.

In the view of the circumstances, an object of the present disclosure is to provide a resin composition containing an acrylic polymer serving as a combustible component, the resin composition having excellent flame resistance with satisfactory adhesion strength to a copper foil and desmear resistance maintained. Further, another object thereof is to provide a prepreg, a laminated plate, a metal-clad laminated plate, a printed wiring board, and a semiconductor package that are produced using the resin composition.

### Solution to Problem

The present inventors have studied to achieve the objects, and as a result, found that the present disclosure can achieve the objects.

The present disclosure includes the following embodiments [1] to [12].
[1] A resin composition containing an acrylic polymer (A), a thermosetting resin (B), and an inorganic filler (C) surface-treated with a silane coupling agent, in which the resin composition further contains a silane coupling agent (D).
[2] The resin composition according to [1], in which the component (A) has a weight-average molecular weight (Mw) of 50,000 to 1,500,000.
[3] The resin composition according to [1] or [2], in which a content of the component (A) is 1 to 50 parts by mass based on 100 parts by mass of a total amount of the components (A) and (B).
[4] The resin composition according to any one of [1] to [3], in which the component (B) contains at least one kind selected from the group consisting of: an epoxy resin, a polyimide resin, a maleimide compound, a phenol resin, a modified polyphenylene ether resin, a bismaleimide triazine resin, a cyanate resin, an isocyanate resin, a benzoxazine resin, an oxetane resin, an amino resin, an unsaturated polyester resin, an allyl resin, a dicyclopentadiene resin, a silicone resin, a triazine resin, and a melamine resin.
[5] The resin composition according to any one of [1] to [4], in which the component (B) contains at least one kind selected from the group consisting of a maleimide compound having two or more N-substituted maleimide groups and a derivative thereof.
[6] The resin composition according to any one of [1] to [5], in which the component (B) contains a siloxane-modified maleimide compound.
[7] The resin composition according to any one of [1] to [6], in which the component (D) has a functional group capable of reacting with the component (A) or (B).
[8] A prepreg including a substrate and the resin composition according to any one of [1] to [7] or a semi-cured product of the resin composition.
[9] A laminated plate including one or more kinds selected from the group consisting of a cured product of the resin composition according to any one of [1] to [7] and a cured product of the prepreg according to [8].
[10] A metal-clad laminated plate including a metal foil, and one or more kinds selected from the group consisting of a cured product of the resin composition according to any one of [1] to [7] and a cured product of the prepreg according to [8].
[11] A printed wiring board including one or more kinds selected from the group consisting of a cured product of the resin composition according to any one of [1] to [7], a cured product of the prepreg according to [8], the laminated plate according to [9], and the metal-clad laminated plate according to [10].
[12] A semiconductor package including the printed wiring board according to [11] and a semiconductor element.

### Advantageous Effects of Invention

According to the present disclosure, provided is a resin composition containing an acrylic polymer serving as a combustible component, the resin composition having excellent flame resistance with satisfactory adhesion strength to a copper foil and desmear resistance maintained. Further, a prepreg, a laminated plate, a metal-clad laminated plate, a printed wiring board, and a semiconductor package that are produced using the resin composition can be provided.

### Description of Embodiments

In a numerical range described in the present disclosure, the upper limit value or the lower limit value of the numerical range may be replaced with a value shown in Examples. In addition, the lower limit value and the upper limit value of the numerical range are each optionally combined with the lower limit value or the upper limit value of another numerical range. The expression "AA to BB" as the numerical value range is a numerical value range containing the numerical values AA and BB that are both ends as the lower limit value and the upper limit value, respectively.

In the present disclosure, for example, the expression "10 or more" means 10 and a numerical value more than 10, and even in the case of different numerical values, the same applies. In addition, for example, the expression "10 or less" means 10 and a value less than 10, and even in the case of different numerical values, the same applies.

One kind of each of components and materials exemplified in the present disclosure may be used alone, or two or more kinds thereof may be used in combination unless otherwise specified. In the present disclosure, if there are a plurality of substances corresponding to each of the components in a resin composition, the amount of each component in the resin composition means the total amount of the substances in the resin composition unless otherwise specified.

In the present disclosure, the term "solids" means components in a resin composition other than an organic solvent to be described later, and a component in liquid form at a room temperature of about 25°C is also regarded as the solids.

The expression "containing XX" described in the present disclosure means that XX may be contained in a reacted state when XX can react, XX may be simply contained in an unaltered state, or XX may be contained in both the states.

In addition, the present embodiment also includes aspects in which items described in the present disclosure are optionally combined.

### [Resin Composition]

An aspect of the embodiment is a resin composition containing an acrylic polymer (A) (hereinafter also referred to as "component (A)"), a thermosetting resin (B) (hereinafter also referred to as "component (B)"), and an inorganic filler (C) surface-treated with a silane coupling agent (hereinafter also referred to as "component (C)"), the resin composition further containing a silane coupling agent (D) (hereinafter also referred to as "component (D)").

Each of the components contained in the resin composition of the embodiment will be described below in turn.

### (Acrylic Polymer (A))

The resin composition of the embodiment contains an acrylic polymer as the component (A), and hence low elasticity and flexibility are improved. The acrylic polymer is a polymer derived from a (meth)acrylic acid ester as a monomer, and is not limited to a polymer derived from an acrylic acid ester as a monomer. In the embodiment, the term "(meth)acrylic acid" indicates both "acrylic acid" and "methacrylic acid", and any one can be selected.

The acrylic polymer may be an acrylic polymer containing a constituent unit derived from a (meth)acrylic acid ester, and is preferably an acrylic polymer containing a structural unit derived from a (meth)acrylic acid ester represented by the following general formula (A1).

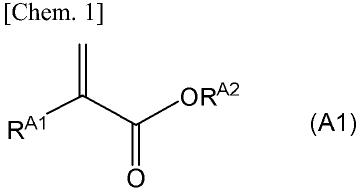

In the formula, R^{A1} represents a hydrogen atom or a methyl group, and R^{A2} represents an alkyl group, a cycloalkyl group, an aryl group, or an aralkyl group.

R^{A1} may be a hydrogen atom or a methyl group, and is preferably a hydrogen atom.

The carbon number of the alkyl group represented by R^{A2} is preferably 1 to 20, more preferably 1 to 15, and still more preferably 2 to 10. Examples of the alkyl group include a methyl group, an ethyl group, a propyl group, a butyl group, and a 2-ethylhexyl group. The alkyl group may have a substituent. Examples of the substituent of the alkyl group include a cycloalkyl group, a hydroxy group, a halogen, an oxygen-containing hydrocarbon group, and a nitrogen-containing cyclic group. The total carbon number of a cycloalkyl-substituted alkyl group is preferably 6 to 13, and more preferably 7 to 10. Examples of the cycloalkyl-substituted alkyl group include a norbornylmethyl group and a tricyclodecylethyl group.

The carbon number of the cycloalkyl group represented by R^{A2} is preferably 6 to 13, and more preferably 7 to 10. Examples of the cycloalkyl group include a cyclohexyl group, a norbornyl group, a tricyclodecanyl group, an isobornyl group, and an adamantyl group. Of these, the cycloalkyl group is preferably a norbornyl group, a tricyclodecanyl group, or an isobornyl group.

The carbon number of the aryl group represented by R^{A2} is preferably 6 to 13, and more preferably 6 to 10. Examples of the aryl group include a phenyl group and a nonylphenyl group.

The carbon number of the aralkyl group represented by R^{A2} is preferably 7 to 15, and more preferably 7 to 11. Examples of the aralkyl group include a benzyl group and a 4-methylbenzyl group.

Specific examples of the component (A) include methyl (meth)acrylate, ethyl (meth)acrylate, propyl (meth)acrylate, butyl (meth)acrylate, hexyl (meth)acrylate, 2-ethylhexyl (meth)acrylate, isobutyl (meth)acrylate, ethylene glycol methyl ether (meth)acrylate, cyclohexyl (meth)acrylate, 2-hydroxyethyl (meth)acrylate, 2-hydroxypropyl (meth)acrylate, isobornyl (meth)acrylate, tricyclo[5.2.1.0(2,6)]deca-8-yl (meth)acrylate, isodecyl (meth)acrylate, octadecyl (meth)acrylate, lauryl (meth)acrylate, allyl (meth)acrylate, norbornylmethyl (meth)acrylate, tricyclodecylethyl (meth)acrylate, phenyl (meth)acrylate, nonylphenyl (meth)acrylate, benzyl (meth)acrylate, and 4-methylbenzyl (meth)acrylate.

The component (A) is not particularly limited, but is preferably an acrylic polymer having a crosslinking functional group. An example of the acrylic polymer having a crosslinking functional group is a copolymer of a (meth)acrylic acid ester and a copolymerizable monomer having a crosslinking functional group (hereinafter also simply referred to as "crosslinking copolymerizable monomer"). The crosslinking copolymerizable monomer preferably has one or more kinds of crosslinking functional groups selected from the group consisting of a carboxy group, a hydroxy group, an amino group, a vinyl group, an epoxy group and the like. Of these, the crosslinking functional group is preferably one or more kinds selected from the group consisting of a carboxy group, a hydroxy group, an amino group, and an epoxy group, and more preferably an epoxy group from the viewpoints of low moisture absorption and solder heat resistance.

The crosslinking copolymerizable monomer is preferably a compound having a double bond.

Examples of the crosslinking copolymerizable monomer include monomers having a carboxy group, such as acrylic acid and methacrylic acid; monomers having an epoxy group, such as glycidyl acrylate and glycidyl methacrylate; monomers having a hydroxy group, such as hydroxyethyl acrylate, hydroxypropyl acrylate, hydroxyethyl methacrylate, and hydroxypropyl methacrylate; monomers having an amino group, such as dimethylaminoethyl acrylate and dimethylaminoethyl methacrylate; monomers having an amide group, such as acrylamide, methacrylamide, dimethylacrylamide, and dimethylmethacrylamide; and monomers having a nitrile group, such as acrylonitrile. One kind of these may be used alone, or two or more kinds thereof may be used in combination. Of these, from the viewpoint of electric insulation reliability, monomers having a carboxy group, monomers having an epoxy group, monomers having a hydroxy group, and monomers having an amino group are preferred; and from the viewpoints of low moisture absorption and solder heat resistance, monomers having an epoxy group are more preferred, and glycidyl acrylate and glycidyl methacrylate are still more preferred.

In addition, the component (A) may be a copolymer of a polymerizable monomer selected from the group consisting of N-pyrrolidone acrylate, N-pyrrolidone methacrylate, N-acryloylmorpholine, N-methacryloylmorpholine, an aromatic vinyl compound, an N-substituted maleimide compound, a (meth)acrylic acid ester other than the (meth)acrylic acid ester represented by the general formula (A1) and the likes, and a (meth)acrylic acid ester.

When the component (A) is a copolymer of the (meth)acrylic acid ester and the crosslinking copolymerizable monomer, the usage amount of the (meth)acrylic acid ester is preferably 70 to 99.5 parts by mass, more preferably 80 to 98 parts by mass, and still more preferably 90 to 97 parts by mass based on 100 parts by mass of the total amount of the (meth)acrylic acid ester and the crosslinking copolymerizable monomer.

The usage amount of the crosslinking copolymerizable monomer is preferably 0.5 to 30 parts by mass, more preferably 2 to 25 parts by mass, and still more preferably 3 to 20 parts by mass based on 100 parts by mass of the total amount of the (meth)acrylic acid ester and the crosslinking copolymerizable monomer. When the usage amount is within such a range, the solder heat resistance, the adhesion strength to a metal foil, the insulation reliability, and the like tend to be improved.

The total content of the (meth)acrylic acid ester and the crosslinking copolymerizable monomer in all the monomers as raw materials of the component (A) is preferably 80% by mass or more, more preferably 90% by mass or more, and still more preferably 95% by mass or more, and may be 100% by mass.

When the component (A) has an epoxy group, the epoxy equivalent of the component is preferably 1,000 to 18,000 g/eq, more preferably 2,000 to 15,000 g/eq, still more preferably 3,000 to 10,000 g/eq, and particularly preferably 3,500 to 7,000 g/eq. When the epoxy equivalent is equal to or more than the lower limit value, the dimensional stability of a substrate tends to be maintained. When it is equal to or less than the upper limit value, a reduction in glass transition temperature of a cured product is suppressed, and the solder heat resistance of the substrate tends to be satisfactory.

In copolymerizing glycidyl (meth)acrylate and another monomer copolymerizable with the glycidyl (meth)acrylate, the epoxy equivalent of the component (A) can be adjusted by appropriately adjusting the copolymerization ratio.

Examples of a commercially available product of the acrylic polymer having an epoxy group include "HTR-860" (manufactured by Nagase ChemteX Corporation, product name, epoxy equivalent: 2,900 g/eq), "TEISANRESIN SG-P3" (manufactured by Nagase ChemteX Corporation, product name, epoxy equivalent: 4,761 to 14,285 g/eq, weight-average molecular weight: 350,000 to 850,000), and "KH-CT-865" (manufactured by Resonac Corporation, product name, epoxy equivalent: 3,300 g/eq).

The weight-average molecular weight (Mw) of the component (A) is preferably 50,000 to 1,500,000, and from the viewpoint of improving the low elasticity and the elongation ratio, it is more preferably 100,000 to 1,300,000, and may be 100,000 to 1,100,000, 100,000 to 950,000, 300,000 to 1,100,000, 500,000 to 1,000,000, or 700,000 to 1,000,000. When the weight-average molecular weight of the component (A) is equal to or more than the lower limit value, a phase separation structure tends to be easily formed without complete compatibility between the components (A) and (B). When it is equal to or less than the upper limit value, the resin composition is easily dissolved in a solvent and tends to have excellent handleability and dispersibility.

The component (A) may be a combination of two or more kinds of acrylic polymers having a different weight-average molecular weight.

In the present description, the weight-average molecular weight is a value measured by gel permeation chromatography (GPC) analysis and means a value expressed in terms of standard polystyrene. The GPC analysis can be performed using tetrahydrofuran (THF) as a solution. A detailed method for measuring a weight-average molecular weight is as described in Examples.

The component (A) may be in powder form at 25°C or in liquid form at 25°C, but is preferably in liquid form at 25°C from the viewpoints of solubility in an organic solvent and dispersibility of an acrylic polymer in a resin composition.

One kind of the component (A) may be used alone, or two or more kinds thereof may be used in combination.

### (Content of Component (A))

The content of the component (A) in the resin composition of the embodiment is not particularly limited, but is preferably 1 to 50 parts by mass, more preferably 3 to 45 parts by mass, still more preferably 5 to 40 parts by mass, particularly preferably 10 to 35 parts by mass, and most preferably 10 to 30 parts by mass, based on 100 parts by mass of the total amount of the components (A) and (B). When the content of the component (A) is equal to or more than the lower limit value, the properties of the component (A) tend to be readily exhibited. When it is equal to or less than the upper limit value, the resin composition tends to have excellent adhesion strength to a metal foil and heat resistance.

### <Thermosetting Resin (B)>

Examples of the component (B) include an epoxy resin, a polyimide resin, a maleimide compound, a phenol resin, a modified polyphenylene ether resin, a bismaleimide triazine resin, a cyanate resin, an isocyanate resin, a benzoxazine resin, an oxetane resin, an amino resin, an unsaturated polyester resin, an allyl resin, a dicyclopentadiene resin, a silicone resin, a triazine resin, and a melamine resin. Of these, the component (B) is preferably an epoxy resin or a maleimide compound.

One kind of the component (B) may be used alone, or two or more kinds thereof may be used in combination.

### (Epoxy Resin)

The epoxy resin is preferably an epoxy resin having two or more epoxy groups in one molecule. Here, the epoxy resin is classified into a glycidyl ether type epoxy resin, a glycidyl amine type epoxy resin, a glycidyl ester type epoxy resin, and the like. Of these, a glycidyl ether type epoxy resin is preferred.

The epoxy resin is classified into various epoxy resins according also to a difference of the main structure, and the above-described epoxy resins of respective types are further classified into:
bisphenol type epoxy resins, such as a bisphenol A type epoxy resin, a bisphenol F type epoxy resin, and a bisphenol S type epoxy resin; alicyclic epoxy resins, such as a dicyclopentadiene type epoxy resin; aliphatic linear epoxy resins; novolac type epoxy resins, such as a phenol novolac type epoxy resin, a cresol novolac type epoxy resin, a bisphenol A type novolac epoxy resin, a bisphenol F novolac type epoxy resin, a phenol aralkyl novolac type epoxy resin, and a biphenyl aralkyl novolac type epoxy resin; stilbene type epoxy resins; naphthalene skeleton-containing epoxy resins, such as a naphthol novolac type epoxy resin and a naphthol aralkyl type epoxy resin; biphenyl type epoxy resins; xylylene type epoxy resins; dihydroanthracene type epoxy resins; and the like.

Of these, from the viewpoints of solder heat resistance and low thermal expansion properties, the epoxy resin is preferably a naphthalene skeleton-containing epoxy resin, and more preferably a naphthol aralkyl type epoxy resin.

The weight-average molecular weight of the epoxy resin may be 200 to 1,000 or 300 to 900. When the weight-average molecular weight of the epoxy resin is equal to or more than the lower limit value, the resin composition tends to have excellent solder heat resistance. When it is equal to or less than the upper limit value, low elasticity and flexibility tend to be readily exhibited.

From the viewpoint of compatibility, the epoxy equivalent of the epoxy resin may be 150 to 500 g/eq, 150 to 450 g/eq, or 150 to 300 g/eq.

### (Maleimide Compound)

The maleimide compound preferably contains at least one kind selected from the group consisting of a maleimide compound (b1) having two or more N-substituted maleimide groups (hereinafter also simply referred to as "maleimide compound (b1)" or "component (b1)") and a derivative thereof. In other words, an aspect in which the component (B) contains at least one kind selected from the group consisting of a maleimide compound having two or more N-substituted maleimide groups and a derivative thereof is preferred.

Examples of the "derivative thereof" include an addition reaction product of the maleimide compound (b1) having two or more N-substituted maleimide groups and an amine compound, such as a diamine compound to be described later.

The maleimide compound (b1) is not particularly limited as long as it is a maleimide compound having two or more N-substituted maleimide groups. Specific examples of the maleimide compound (b1) include aromatic maleimide compounds, such as bis(4-maleimidophenyl)methane, polyphenylmethanemaleimide, bis(4-maleimidophenyl) ether, bis(4-maleimidophenyl)sulfone, 3,3'-dimethyl-5,5'-diethyl-4,4'-diphenylmethanebismaleimide, 4-methyl-1,3-phenylenebismaleimide, m-phenylenebismaleimide, and 2,2-bis[4-(4-maleimidophenoxy)phenyl]propane; and aliphatic maleimide compounds, such as 1,6-bismaleimido-(2,2,4-trimethyl)hexane, and pyrophosphate binder type long-chain alkyl bismaleimide. Of these, from the viewpoints of adhesive properties to a metal foil and mechanical properties, the maleimide compound (b1) is preferably an aromatic maleimide compound, more preferably an aromatic bismaleimide compound, and still more preferably 2,2-bis[4-(4-maleimidophenoxy)phenyl]propane or 3,3'-dimethyl-5,5'-diethyl-4,4'-diphenylmethanebismaleimide.

The maleimide compound (b1) is preferably a compound represented by the following general formula (B1-1).

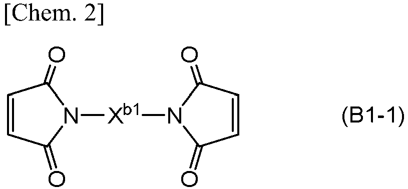

In the formula, X^{b1} represents a divalent organic group.

Examples of the divalent organic group, which is represented by X^{b1} in the general formula (B1-1), include a group represented by the following general formula (B1-2), (B1-3), (B1-4), or (B1-5).

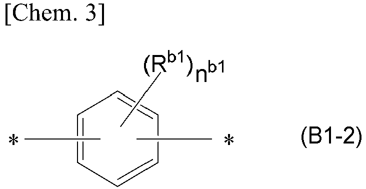

In the formula, R^{b1} represents an aliphatic hydrocarbon group having 1 to 5 carbon atoms or a halogen atom, n^{b1} represents an integer of 0 to 4, and * represents a bonding position.

Examples of the aliphatic hydrocarbon group having 1 to 5 carbon atoms, which is represented by R^{b1}, include a methyl group, an ethyl group, an n-propyl group, an isopropyl group, an n-butyl group, an isobutyl group, a t-butyl group, and an n-pentyl group. The aliphatic hydrocarbon group is preferably an aliphatic hydrocarbon group having 1 to 3 carbon atoms, and more preferably a methyl group.

n^{b1} represents an integer of 0 to 4, and from the viewpoint of ease of availability, n^{b1} is preferably an integer of 0 to 2, and more preferably 0. When n^{b1} is an integer of 2 or more, a plurality of R^{b1}'s may be the same as or different from each other.

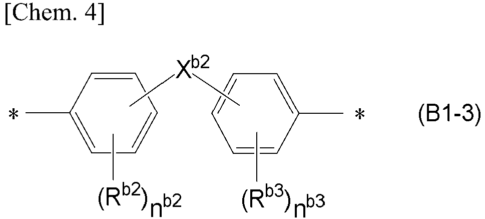

In the formula, R^{b2} and R^{b3} each independently represent an aliphatic hydrocarbon group having 1 to 5 carbon atoms or a halogen atom, X^{b2} represents an alkylene group having 1 to 5 carbon atoms, an alkylidene group having 2 to 5 carbon atoms, an ether group, a sulfide group, a sulfonyl group, a carbonyloxy group, a keto group, a single bond, or a divalent group represented by the following general formula (B1-3-1). n^{b2} and n^{b3} each independently represent an integer of 0 to 4, and * represents a bonding position.

The description of the aliphatic hydrocarbon group having 1 to 5 carbon atoms, which is represented by R^{b2} and R^{b3}, is the same as the description of the aliphatic hydrocarbon group having 1 to 5 carbon atoms, which is represented by R^{b1} in the general formula (B1-2).

Examples of the alkylene group having 1 to 5 carbon atoms, which is represented by X^{b2}, include a methylene group, a 1,2-dimethylene group, a 1,3-trimethylene group, a 1,4-tetramethylene group, and a 1,5-pentamethylene group. The alkylene group is preferably an alkylene group having 1 to 3 carbon atoms, and more preferably a methylene group.

Examples of the alkylidene group having 2 to 5 carbon atoms, which is represented by X^{b2}, include an ethylidene group, a propylidene group, an isopropylidene group, a butylidene group, an isobutylidene group, a pentylidene group, and an isopentylidene group. The alkylidene group is preferably an isopropylidene group.

n^{b2} and n^{b3} represent an integer of 0 to 4, and from the viewpoint of ease of availability, n^{b2} and n^{b3} are preferably an integer of 0 to 2, and more preferably 0 or 2. When n^{b2} is an integer of 2 or more, a plurality of R^{b2}'s may be the same as or different from each other. When n^{b3} is an integer of 2 or more, a plurality of R^{b3}'s may be the same as or different from each other.

The divalent group represented by the general formula (B1-3-1), which is represented by X^{b2}, is as described below.

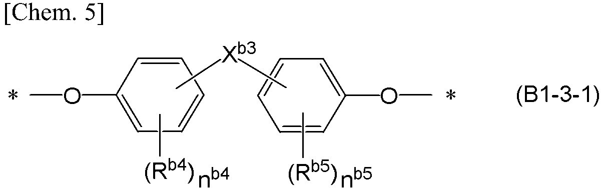

In the formula, R^{b4} and R^{b5} each independently represent an aliphatic hydrocarbon group having 1 to 5 carbon atoms or a halogen atom, X^{b3} represents an alkylene group having 1 to 5 carbon atoms, an alkylidene group having 2 to 5 carbon atoms, an ether group, a sulfide group, a sulfonyl group, a carbonyloxy group, a keto group, or a single bond, n^{b4} and n^{b5} each independently represent an integer of 0 to 4, and * represents a bonding position.

The description of the aliphatic hydrocarbon group having 1 to 5 carbon atoms, which is represented by R^{b4} and R^{b5}, is the same as the description of the aliphatic hydrocarbon group having 1 to 5 carbon atoms, which is represented by R^{b1} in the general formula (B1-2).

Examples of the alkylene group having 1 to 5 carbon atoms and the alkylidene group having 2 to 5 carbon atoms, which are represented by X^{b3}, are the same as the examples of the alkylene group having 1 to 5 carbon atoms and the alkylidene group having 2 to 5 carbon atoms, which are represented by X^{b2} in the general formula (B1-3). Of these, from the viewpoints of adhesive properties to a metal foil, solder heat resistance, glass transition temperature, and thermal expansion coefficient, an isopropylidene group is preferred.

Of the groups represented by X^{b3}, an alkylidene group having 2 to 5 carbon atoms is preferred, and an isopropylidene group is more preferred.

n^{b4} and n^{b5} represent an integer of 0 to 4, and from the viewpoint of ease of availability, n^{b4} and n^{b5} are preferably an integer of 0 to 2, and more preferably 0. When n^{b4} is an integer of 2 or more, a plurality of R^{b4}'s may be the same as or different from each other. When n^{b5} is an integer of 2 or more, a plurality of R^{b5}'s may be the same as or different from each other.

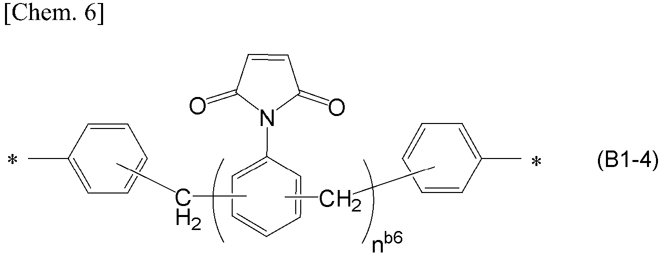

In the formula, n^{b6} represents an integer of 1 to 10, and * represents a bonding position.

From the viewpoint of ease of availability, n^{b6} is preferably an integer of 1 to 5, and more preferably an integer of 1 to 3.

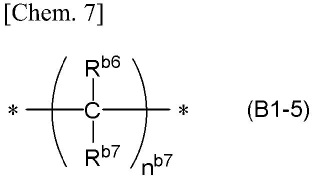

In the formula, R^{b6} and R^{b7} each independently represent a hydrogen atom or an aliphatic hydrocarbon group having 1 to 5 carbon atoms, n^{b7} represents an integer of 1 to 8, and * represents a bonding position.

The description of the aliphatic hydrocarbon group having 1 to 5 carbon atoms, which is represented by R^{b6} and R^{b7}, is the same as the description of the aliphatic hydrocarbon group having 1 to 5 carbon atoms, which is represented by R^{b1} in the general formula (B1-2).

n^{b7} represents an integer of 1 to 8, and is preferably an integer of 1 to 3, and more preferably 1.

When n^{b7} is an integer of 2 or more, a plurality of R^{b6}'s may be the same as or different from each other, and a plurality of R^{b7}'s may be the same as or different from each other.

From the viewpoints of dielectric constant and dielectric loss tangent (hereinafter they are referred to as "dielectric properties"), X^{b1} in the general formula (B1-1) is preferably a divalent group represented by any one of the following formulae (X^{b1}-1) to (X^{b1}-3), and more preferably a divalent group represented by the following formula (X^{b1}-3).

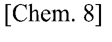

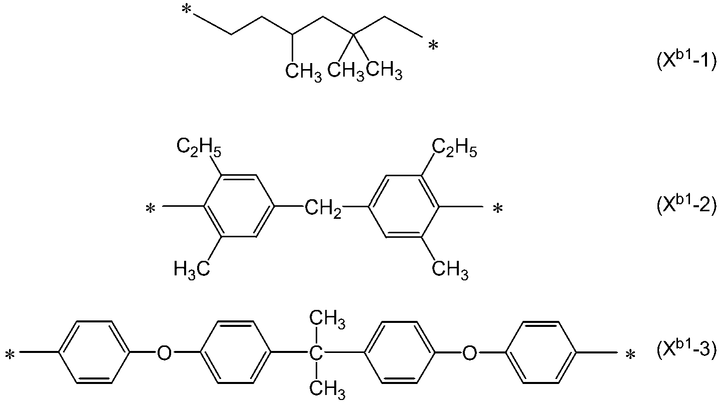

In the formulae, * represents a bonding position to a nitrogen atom in a maleimide group.

From the viewpoints of solubility in an organic solvent, compatibility, adhesive properties to a metal foil, and dielectric properties, the maleimide compound is preferably a derivative of the maleimide compound (b1).

The derivative of the maleimide compound (b1) is preferably a modified maleimide compound (Z) (hereinafter also abbreviated as "modified maleimide compound (Z)" or "component (Z)") having a structural unit derived from the maleimide compound (b1) and a structural unit derived from an amine compound (b2) having a primary amino group (hereinafter also abbreviated as "amine compound (b2)" or "component (b2)").

That is, an aspect in which the resin composition of the embodiment contains as the component (B) the maleimide compound and the maleimide compound is a modified maleimide compound having a structural unit derived from the maleimide compound (b1) having at least two or more N-substituted maleimide groups and a structural unit derived from the amine compound (b2) having a primary amino group is preferred.

The structural unit derived from the component (b1) and the structural unit derived from the component (b2), contained in the modified maleimide compound (Z), may be each one kind or a combination of two or more kinds.

The modified maleimide compound (Z) is preferably a compound containing a structure represented by the following formula (B-1) that is obtained by addition reaction of the maleimide groups of the component (b1) and the primary amino group of the component (b2). 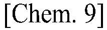 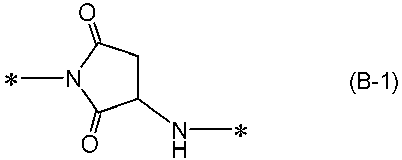 * represents a bonding position to another structure.

Examples of the structural unit derived from the component (b1) include one or more kinds selected from the group consisting of a group represented by the following general formula (B1-6) and a group represented by the following general formula (B1-7). 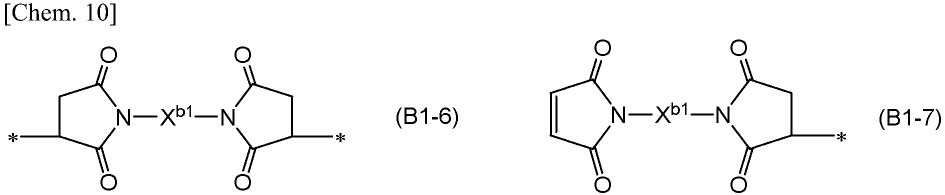 In the formulae, X^{b1} is the same as X^{b1} in the general formula (B1-1), and * represents a bonding position to another structure.

The content of the structural unit derived from the component (b1) in the modified maleimide compound (Z) is not particularly limited, but is preferably 50 to 95% by mass, more preferably 70 to 92% by mass, and still more preferably 75 to 90% by mass. When the content of the structural unit derived from the component (b1) is within the above-described range, dielectric properties tend to be satisfactory.

The amine compound (b2) is preferably a compound having two or more amino groups, and more preferably a diamine compound having two amino groups.

Examples of the amine compound (b2) include aromatic diamine compounds, such as 4,4'-diaminodiphenylmethane, 4,4'-diamino-3,3'-dimethyldiphenylmethane, 3,3'-diethyl-4,4'-diaminodiphenylmethane, 4,4'-diaminodiphenyl ether, 4,4'-diaminodiphenyl sulfone, 3,3'-diaminodiphenyl sulfone, 4,4'-diaminodiphenyl ketone, 4,4'-diaminobiphenyl, 3,3'-dimethyl-4,4'-diaminobiphenyl, 2,2'-dimethyl-4,4'-diaminobiphenyl, 3,3'-dihydroxybenzidine, 2,2-bis(3-amino-4-hydroxyphenyl)propane, 3,3'-dimethyl-5,5'-diethyl-4,4'-diaminodiphenylmethane, 2,2-bis(4-aminophenyl)propane, 2,2-bis[4-(4-aminophenoxy)phenyl]propane, 1,3-bis(3-aminophenoxy)benzene, 1,3-bis(4-aminophenoxy)benzene, 1,4-bis(4-aminophenoxy)benzene, 4,4'-bis(4-aminophenoxy)biphenyl, 1,3-bis[1-[4-(4-aminophenoxy)phenyl]-1-methylethyl]benzene, 1,4-bis[1-[4-(4-aminophenoxy)phenyl]-1-methylethyl]benzene, 4,4'-[1,3-phenylenebis(1-methylethylidene)]bisanilne, 4,4'-[1,4-phenylenebis(1-methylethylidene)]bisanilne, 3,3'-[1,3-phenylenebis(1-methylethylidene)]bisanilne, bis[4-(4-aminophenoxy)phenyl]sulfone, bis[4-(3-aminophenoxy)phenyl]sulfone, and 9,9-bis(4-aminophenyl)fluorene; and amine-modified siloxane compounds having a primary amino group.

Of these, from the viewpoint of low thermal expansion properties, the component (b2) is preferably an amine-modified siloxane compound having a primary amino group.

That is, the modified maleimide compound (Z) is preferably a siloxane-modified maleimide compound (Z). In other words, the component (B) preferably contains a siloxane-modified maleimide compound.

The amine compound (b2) is preferably a compound represented by the following general formula (B2-1).
[Chem. 11]

H₂N-X^{b4}-NH₂ (B2-1)

In the formula, X^{b4} represents a divalent organic group.

The component (b2) preferably contains an aromatic diamine compound (hereinafter also abbreviated as "aromatic diamine compound (B2-2)) in which X^{b4} in the general formula (B2-1) is a divalent group represented by the following general formula (B2-2).

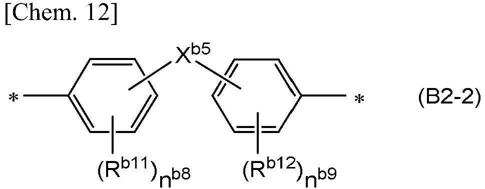

In the formula, R^{b11} and R^{b12} each independently represent an aliphatic hydrocarbon group having 1 to 5 carbon atoms, an alkoxy group having 1 to 5 carbon atoms, a hydroxy group, or a halogen atom, X^{b5} represents an alkylene group having 1 to 5 carbon atoms, an alkylidene group having 2 to 5 carbon atoms, an ether group, a sulfide group, a sulfonyl group, a carbonyloxy group, a keto group, a fluorenylene group, a single bond, or a divalent group represented by the following general formula (B2-2-1) or (B2-2-2), n^{b8} and n^{b9} each independently represent an integer of 0 to 4, and * represents a bonding position.

Examples of the aliphatic hydrocarbon group having 1 to 5 carbon atoms, which is represented by R^{b11} and R^{b12} in the general formula (B2-2), include a methyl group, an ethyl group, an n-propyl group, an isopropyl group, an n-butyl group, an isobutyl group, a t-butyl group, and an n-pentyl group.

Examples of the alkylene group having 1 to 5 carbon atoms, which is represented by X^{b5}, include a methylene group, a 1,2-dimethylene group, a 1,3-trimethylene group, a 1,4-tetramethylene group, and a 1,5-pentamethylene group.

Examples of the alkylidene group having 2 to 5 carbon atoms, which is represented by X^{b5}, include an ethylidene group, a propylidene group, an isopropylidene group, a butylidene group, an isobutylidene group, a pentylidene group, and an isopentylidene group.

n^{b8} and n^{b9} represent an integer of 0 to 4, and from the viewpoint of ease of availability, n^{b8} and n^{b9} are preferably 0 or 1. When n^{b8} or n^{b9} is an integer of 2 or more, a plurality of R^{b11}'s or a plurality of R^{b12}'s may be the same as or different from each other.

The divalent group represented by the general formula (B2-2-1), which is represented by X^{b5} in the general formula (B2-2), is as described below.

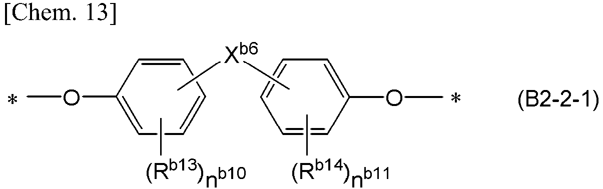

In the formula, R^{b13} and R^{b14} each independently represent an aliphatic hydrocarbon group having 1 to 5 carbon atoms or a halogen atom, X^{b6} represents an alkylene group having 1 to 5 carbon atoms, an alkylidene group having 2 to 5 carbon atoms, a m-phenylenediisopropylidene group, a p-phenylenediisopropylidene group, an ether group, a sulfide group, a sulfonyl group, a carbonyloxy group, a keto group, or a single bond, n^{b10} and n^{b11} each independently represent an integer of 0 to 4, and * represents a bonding position.

The description of the aliphatic hydrocarbon group having 1 to 5 carbon atoms, which is represented by R^{b13} and R^{b14} in the general formula (B2-2-1), is the same as the description of the aliphatic hydrocarbon group having 1 to 5 carbon atoms, which is represented by R^{b11} and R^{b12} in the general formula (B2-2).

The description of the alkylene group having 1 to 5 carbon atoms and the alkylidene group having 2 to 5 carbon atoms represented by X^{b6} is the same as the description of the alkylene group having 1 to 5 carbon atoms and the alkylidene group having 2 to 5 carbon atoms represented by X^{b5} in the general formula (B2-2).

n^{b10} and n^{b11} represent an integer of 0 to 4, and from the viewpoint of ease of availability, n^{b10} and n^{b11} are preferably an integer of 0 to 2, and more preferably 0. When n^{b10} is an integer of 2 or more, a plurality of R^{b13}'s may be the same as or different from each other. When n^{b11} is an integer of 2 or more, a plurality of R^{b14}'s may be the same as or different from each other.

The divalent group represented by the general formula (B2-2-2), which is represented by X^{b5} in the general formula (B2-2), is as described below.

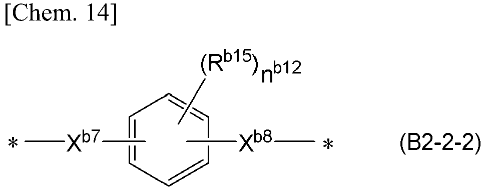

In the formula, R^{b15} represents an aliphatic hydrocarbon group having 1 to 5 carbon atoms or a halogen atom, X^{b7} and X^{b8} each independently represent an alkylene group having 1 to 5 carbon atoms, an alkylidene group having 2 to 5 carbon atoms, an ether group, a sulfide group, a sulfonyl group, a carbonyloxy group, a keto group, or a single bond, n^{b12} represents an integer of 0 to 4, and * represents a bonding position.

The description of the aliphatic hydrocarbon group having 1 to 5 carbon atoms represented by R^{b15} in the general formula (B2-2-2) is the same as the description of the aliphatic hydrocarbon group having 1 to 5 carbon atoms, which is represented by R^{b11} and R^{b12} in the general formula (B2-2).

As the alkylene group having 1 to 5 carbon atoms and the alkylidene group having 2 to 5 carbon atoms represented by X^{b7} and X^{b8}, those the same as the alkylene group having 1 to 5 carbon atoms and the alkylidene group having 2 to 5 carbon atoms represented by X^{b5} in the general formula (B2-2) are exemplified. Of these, X^{b7} and X^{b8} are preferably an alkylidene group having 2 to 5 carbon atoms, and more preferably an isopropylidene group.

n^{b12} represents an integer of 0 to 4, and from the viewpoint of ease of availability, n^{b12} is preferably an integer of 0 to 2, and more preferably 0. When n^{b12} is an integer of 2 or more, a plurality of R^{b15}'s may be the same as or different from each other.

In addition, from the viewpoint of low thermal expansion properties, the component (b2) preferably contains an "amine-modified siloxane compound" in which X^{b4} in the general formula (B2-1) contains a structural unit represented by the following general formula (B2-3). The component (b2) more preferably contains a "terminal amine-modified siloxane compound" in which X^{b4} in the general formula (B2-1) contains a structural unit represented by the following general formula (B2-4).

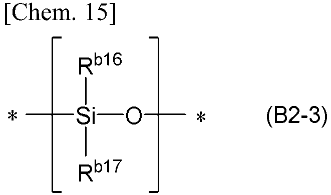

In the formula, R^{b16} and R^{b17} each independently represent an alkyl group having 1 to 5 carbon atoms, a phenyl group, or a substituted phenyl group, and * represents a bonding position.

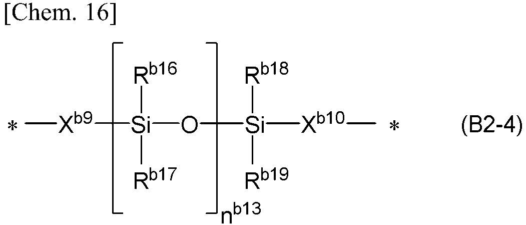

In the formula, R^{b16} and R^{b17} are the same as those in the general formula (B2-3), R^{b18} and R^{b19} each independently represent an alkyl group having 1 to 5 carbon atoms, a phenyl group, or a substituted phenyl group, X^{b9} and X^{b10} each independently represent a divalent organic group, n^{b13} represents an integer of 2 to 100, and * represents a bonding position.

Examples of the alkyl group having 1 to 5 carbon atoms, which is represented by R^{b16} to R^{b19} in the general formulae (B2-3) and (B2-4), include a methyl group, an ethyl group, an n-propyl group, an isopropyl group, an n-butyl group, an isobutyl group, a t-butyl group, and an n-pentyl group. The alkyl group is preferably an alkyl group having 1 to 3 carbon atoms, and more preferably a methyl group.

Examples of a substituent of a phenyl group in the substituted phenyl group, which is represented by R^{b16} to R^{b19}, include an alkyl group having 1 to 5 carbon atoms, an alkenyl group having 2 to 5 carbon atoms, and an alkynyl group having 2 to 5 carbon atoms. Examples of the alkyl group having 1 to 5 carbon atoms include a methyl group, an ethyl group, an n-propyl group, an isopropyl group, an n-butyl group, an isobutyl group, a t-butyl group, and an n-pentyl group. Examples of the alkenyl group having 2 to 5 carbon atoms include a vinyl group and an allyl group. Examples of the alkynyl group having 2 to 5 carbon atoms include an ethynyl group and a propargyl group.

Examples of the divalent organic group, which is represented by X^{b9} and X^{b10}, include an alkylene group, an alkenylene group, an alkynylene group, an arylene group, and a divalent linking group in which -O- or they are combined. Examples of the alkylene group include alkylene groups having 1 to 10 carbon atoms, such as a methylene group, an ethylene group, and a propylene group. Examples of the alkenylene group include an alkenylene group having 2 to 10 carbon atoms. Examples of the alkynylene group include an alkynylene group having 2 to 10 carbon atoms. Examples of the arylene group include arylene groups having 6 to 20 carbon atoms, such as a phenylene group and a naphthylene group.

Of these, X^{b9} and X^{b10} are preferably an alkylene group or an arylene group, and more preferably an alkylene group.

n^{b13} represents an integer of 2 to 100, preferably an integer of 2 to 50, more preferably an integer of 3 to 40, and still more preferably an integer of 5 to 30. When n^{b13} is an integer of 2 or more, a plurality of R^{b16}'s or a plurality of R^{b17}'s may be the same as or different from each other.

Examples of the structural unit derived from the component (b2) include one or more kinds selected from the group consisting of a group represented by the following general formula (B2-5) and a group represented by the following general formula (B2-6).

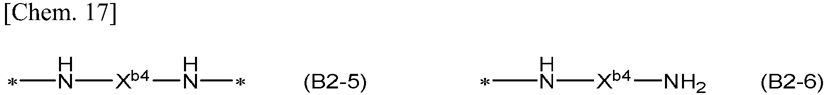

In the formulae, X^{b4} is the same as X^{b4} in the general formula (B2-1), and * represents a bonding position.

The content of the structural unit derived from the component (b2) in the modified maleimide compound (Z) is not particularly limited, but is preferably 5 to 50% by mass, more preferably 8 to 30% by mass, and still more preferably 10 to 25% by mass. When the content of the structural unit derived from the component (b2) is within the above-described range, the resin composition tends to have excellent low thermal expansion properties and dielectric properties, and have satisfactory solder heat resistance, flame resistance, and glass transition temperature.

The total content of the structural unit derived from the component (b1) and the structural unit derived from the component (b2) in the modified maleimide compound (Z) is not particularly limited, but is preferably 80% by mass or more, more preferably 90% by mass or more, still more preferably 95% by mass or more, and particularly preferably 100% by mass (that is, containing only the structural unit derived from the component (b1) and the structural unit derived from the component (b2)).

The content ratio of the structural unit derived from the component (b1) and the structural unit derived from the component (b2) in the modified maleimide compound (Z) is not particularly limited, but the equivalent ratio (Ta1/Ta2) of the total equivalent (Ta1) of a group derived from a maleimide group (including a maleimide group) derived from the component (b1) to the total equivalent (Ta2) of a group derived from a -NH₂ group (including -NH₂) of the component (b2) is preferably 0.05 to 10, and more preferably 2 to 8. When the equivalent ratio (Ta1/Ta2) is within the above-described range, the resin composition tends to have excellent low thermal expansion properties and dielectric properties, and have satisfactory solder heat resistance, flame resistance, and glass transition temperature.

From the viewpoints of dielectric properties, insulation reliability, solubility in an organic solvent, adhesive properties to a metal foil, moldability, and the like, the maleimide compound preferably contains a compound represented by the following general formula (B-2).

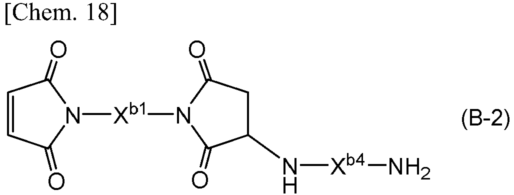

In the formula, X^{b1} and X^{b4} are as described in the general formulae (b1-1) and (b2-1).

### (Method for Producing Modified Maleimide Compound (Z))

The component (Z) can be produced, for example, by reacting the components (b1) and (b2) in an organic solvent.

Specifically, the components (b1) and (b2), and if necessary, another component in predetermined amounts are loaded into a reactor, and the components (b1) and (b2) are subjected to a Michael addition reaction (hereinafter also referred to as "pre-reaction") to obtain the modified maleimide compound (Z).

A reaction condition is not particularly limited, but from the viewpoint of achieving satisfactory reactivity and workability with gelation being suppressed, the reaction temperature is preferably 50 to 160°C, and more preferably 90 to 140°C, and the reaction time is preferably 1 to 10 hours, and more preferably 1 to 5 hours.

In the pre-reaction, a reaction catalyst may be used, if necessary. Examples of the reaction catalyst include acidic catalysts, such as p-toluenesulfonic acid; amines, such as triethylamine, pyridine, and tributylamine; imidazole-based compounds, such as methylimidazole and phenylimidazole; and phosphorus-based catalysts, such as triphenylphosphine. One kind of the reaction catalysts may be used alone, or two or more kinds thereof may be used in combination. In addition, the blending amount of the reaction catalyst is not particularly limited, but is, for example, 0.01 to 5 parts by mass based on 100 parts by mass of the total amount of the components (b1) and (b2).

In the pre-reaction, an organic solvent may be added or concentrated, if necessary, to adjust the solids concentration of a reaction raw material and the viscosity of a reaction liquid. The solids concentration of the reaction raw material is not particularly limited, but is preferably 10 to 90% by mass, and more preferably 20 to 80% by mass. When the solids concentration of the reaction raw material is equal to or more than the lower limit value, a sufficient reaction rate is achieved and the pre-reaction tends to be advantageous in terms of production cost. When it is equal to or less the upper limit value, there is a tendency to achieve satisfactory solubility, improve stirring efficiency, and be less likely to gel.

The weight-average molecular weight (Mw) of the modified maleimide compound (Z) is not particularly limited, but is preferably 400 to 10,000, more preferably 1,000 to 5,000, still more preferably 1,500 to 4,000, and particularly preferably 2,000 to 3,000.

### (Content of Component (B))

The content of the component (B) in the resin composition of the embodiment is preferably 50 to 99 parts by mass, more preferably 55 to 97 parts by mass, still more preferably 60 to 95 parts by mass, particularly preferably 65 to 90 parts by mass, and most preferably 70 to 90 parts by mass, based on 100 parts by mass of the total amount of the components (A) and (B). When the content of the component (B) is equal to or more than the lower limit value, the resin composition tends to have excellent adhesion strength to a metal foil and solder heat resistance. When it is equal to or less than the upper limit value, the properties of the component (A) tend to be readily exhibited.

### <Inorganic Filler (C) surface-treated with Silane Coupling Agent>

The resin composition of the embodiment further contains as the component (C) an inorganic filler surface-treated with a silane coupling agent. An inorganic filler is surface-treated with a silane coupling agent, and hence the component (C) can suppress a reduction in an effect caused by incorporating a silane coupling agent (D) into the resin composition of the embodiment. That is, the component (C) is surface-treated with a silane coupling agent, and hence the use of the silane coupling agent (D) for surface treatment of the inorganic filler can be suppressed, to fully exhibit an effect caused by the component (D). From this viewpoint, the component (C) preferably contains 80% by mass or more (preferably 90% by mass or more, which includes 100% by mass. Hereinafter, the same applies) of the inorganic filler in which the surface treated with a silane coupling agent accounts for 70% or more, more preferably contains 80% by mass or more of the inorganic filler in which the surface treated with a silane coupling agent accounts for 80% or more, still more preferably contains 80% by mass or more of the inorganic filler in which the surface treated with a silane coupling agent accounts for 90% or more, particularly preferably contains 80% by mass or more of the inorganic filler in which the surface treated with a silane coupling agent accounts for 98% or more, and most preferably contains 80% by mass or more of the inorganic filler in which the surface treated with a silane coupling agent accounts for 100% or more.

Examples of a material for the component (C) include silica, alumina, titanium oxide, mica, beryllia, barium titanate, potassium titanate, strontium titanate, calcium titanate, aluminum carbonate, magnesium hydroxide, aluminum hydroxide, aluminum silicate, calcium carbonate, calcium silicate, magnesium silicate, silicon nitride, boron nitride, clay (calcined clay, and the like), a molybdic acid compound (zinc molybdate, and the like), talc, aluminum borate, and silicon carbide. One kind of the component (C) may be used alone, or two or more kinds thereof may be used in combination. Of these, from the viewpoints of low thermal expansion properties, heat resistance, and flame resistance, silica, alumina, mica, and talc are preferred, silica and alumina are more preferred, and silica is still more preferred.

Examples of the silica include precipitated silica and dry process silica. The precipitated silica is produced by a wet method and has high water content. The dry process silica is produced by a dry method and hardly contains bound water and the like. Examples of the dry process silica include crushed silica, fumed silica, and molten silica.

Examples of a silane coupling agent used in the surface treatment of the inorganic filler in the component (C) include an aminosilane-based coupling agent, an epoxysilane-based coupling agent, a phenylsilane-based coupling agent, an alkylsilane-based coupling agent, an alkenylsilane-based coupling agent, an alkynylsilane-based coupling agent, and a silicone oligomer-based coupling agent. Of these, an aminosilane-based coupling agent, an epoxysilane-based coupling agent, and a phenylsilane-based coupling agent are preferred, an aminosilane-based coupling agent and a phenylsilane-based coupling agent are more preferred, and a phenylsilane-based coupling agent is still more preferred. One kind of the silane coupling agent may be used alone, or two or more kinds thereof may be used in combination.

The average particle diameter of the component (C) is preferably 0.1 to 2.5 µm, more preferably 0.2 to 1.5 µm, and still more preferably 0.3 to 0.8 µm. When the average particle diameter of the component (C) is equal to or more than the lower limit value, a filler is likely to be dispersed in a resin varnish, and hence there is a tendency for coagulation to be less likely to occur. When it is equal to or less than the upper limit value, there is a tendency for precipitation of the component (C) in the resin varnish to be less likely to occur.

Here, the average particle diameter represents the particle diameter at the point corresponding to 50% of the volume in determining a cumulative distribution curve based on particle diameter with the total volume of particles taken as 100%, and can be measured with a particle size distribution analyzer using the laser diffraction scattering method, or the like.

### (Content of Component (C))

The content of the component (C) in the resin composition of the embodiment is not particularly limited, but is preferably 30 to 300 parts by mass, more preferably 50 to 250 parts by mass, still more preferably 70 to 200 parts by mass, particularly preferably 100 to 200 parts by mass, and most preferably 130 to 170 parts by mass, based on 100 parts by mass of the total amount of the components (A) and (B). When the content of the component (C) is equal to or more than the lower limit value, the resin composition tends to have excellent low thermal expansion properties and have high heat resistance. When the content of the component (C) is equal to or less than the upper limit value, the properties of the component (A) tend to be readily exhibited.

### <Silane Coupling Agent (D)>

The resin composition of the embodiment further contains as the component (D) a silane coupling agent. The silane coupling agent is a compound having a substituted silyl group. Examples of a substituent of the substituted silyl group include a hydroxy group; alkyl groups, such as a methyl group; alkoxy groups, such as a methoxy group and an ethoxy group; and carboxy groups. The substituent of the substituted silyl group is bound to a silicon atom, and the number of the substituents is 1 to 3, and may be 3. When the number of the substituents of a compound having the substituted silyl group is 3, the compound may be referred to as a compound having a tri-substituted silyl group.

The component (D) preferably has a functional group capable of reacting with the component (A) or (B). The component (D) can be classified according to the kind of the functional group, and examples of the component (D) include an aminosilane-based coupling agent, an epoxysilane-based coupling agent, a phenylsilane-based coupling agent, an alkylsilane-based coupling agent, an alkenylsilane-based coupling agent, an alkynylsilane-based coupling agent, a silicone oligomer-based coupling agent, a (meth)acrylic silane-based coupling agent, an isocyanate silane-based coupling agent, an isocyanurate silane-based coupling agent, a ureidosilane-based coupling agent, a mercaptosilane-based coupling agent, a carboxysilane-based coupling agent, and an alkylene glycol silane-based coupling agent. Of these, from the viewpoints of adhesion strength to a copper foil, desmear resistance, and flame resistance, an aminosilane-based coupling agent, an epoxysilane-based coupling agent, a phenylsilane-based coupling agent, and an alkenylsilane-based coupling agent are preferred, and an aminosilane-based coupling agent, an epoxysilane-based coupling agent, and an alkenylsilane-based coupling agent are more preferred.

Examples of the alkenylsilane-based coupling agent include a vinylsilane-based coupling agent.

One kind of the component (D) may be used alone, or two or more kinds thereof may be used in combination.

A commercially available product can be used for the component (D). Examples of the commercially available product include KBM series and KBE series, manufactured by Shin-Etsu Chemical Co., Ltd., and silane coupling agents manufactured by Dow Toray, Co., Ltd.

### (Content of Component (D))

The content of the component (D) in the resin composition of the embodiment is not particularly limited, but is preferably 0.01 to 5 parts by mass, more preferably 0.05 to 2 parts by mass, still more preferably 0.1 to 1.5 parts by mass, particularly preferably 0.1 to 1.0 parts by mass, and most preferably 0.1 to 0.7 parts by mass, based on 100 parts by mass of the total amount of the components (A) and (B). When the content of the component (D) is equal to or more than the lower limit value, in a resin composition containing the component (A) as a combustible component, there is a tendency for flame resistance to be likely to be improved with satisfactory adhesion strength to a copper foil and desmear resistance maintained. When the content of the component (D) is equal to or less than the upper limit value, there is a tendency for satisfactory adhesion strength to a copper foil to be likely to be maintained.

### <Curing Accelerator (E)>

The resin composition of the embodiment may contain a curing accelerator (E) (hereinafter also referred to as "component (E)"). One kind of the component (E) may be used alone, or two or more kinds thereof may be used in combination.

For example, when the thermosetting resin (B) contains an epoxy resin or a maleimide compound, the curing accelerator (E) is not particularly limited, but the curing accelerator (E) preferably contains one or more kinds selected from the group consisting of an amine compound and an imidazole-based compound, and more preferably contains an imidazole-based compound.

Examples of the amine compound include dicyandiamide, diaminodiphenylethane, and guanylurea.

Examples of the imidazole-based compound include 2-phenylimidazole, 1-cyanoethyl-2-methylimidazole, 1-cyanoethyl-2-undecylimidazole, 1-cyanoethyl-2-phenylimidazole, 1-cyanoethyl-2-phenylimidazolium trimellitate, benzimidazole, and isocyanate-masked imidazole (e.g., an addition reaction product of a hexamethylene diisocyanate resin and 2-ethyl-4-methylimidazole).

### (Content of Component (E))

When the resin composition of the embodiment contains the component (E), the content of the component (E) is not particularly limited, but is preferably 0.01 to 10 parts by mass, more preferably 0.03 to 2 parts by mass, and still more preferably 0.1 to 1 part by mass, based on 100 parts by mass of the total amount of the components (A) and (B).

### <Other Component>

The resin composition of the embodiment may contain a resin other than the component (B), an elastomer other than the component (A), a curing agent, a crosslinking agent, a flame retardant, a flame retardant promoter, conductive particles, a coupling agent, a flow modifier, an antioxidant, a thermal stabilizer, an antistat, a pigment, a leveling agent, a defoamer, an ion trapping agent, or the like, if necessary. As these other components, known materials can be used.

The resin composition of the embodiment may be in a dissolution or dispersion state in an organic solvent, or a so-called "resin varnish" state. Hereinafter, a resin composition containing an organic solvent may be referred to as a resin varnish.

Examples of the organic solvent include ketone-based solvents, such as acetone, methyl ethyl ketone, methyl isobutyl ketone, and cyclohexanone; aromatic hydrocarbon-based solvents, such as toluene and xylene; ester-based solvents, such as methoxyethyl acetate, ethoxyethyl acetate, butoxyethyl acetate, and ethyl acetate; amide-based solvents, such as N-methylpyrrolidone, formamide, N-methyl formamide, and N,N-dimethyl acetamide; and alcoholic solvents, such as methanol, ethanol, ethylene glycol, ethylene glycol monomethyl ether, ethylene glycol monoethyl ether, diethylene glycol, triethylene glycol monomethyl ether, triethylene glycol monoethyl ether, triethylene glycol, propylene glycol monomethyl ether, dipropylene glycol monomethyl ether, propylene glycol monopropyl ether, and dipropylene glycol monopropyl ether. One kind of the organic solvent may be used alone, or two or more kinds thereof may be used in combination.

The solids concentration in the varnish is preferably 10 to 70% by mass, more preferably 20 to 60% by mass, and still more preferably 35 to 60% by mass.

### [Prepreg]

A prepreg of the embodiment includes a substrate and the resin composition of the embodiment or a semi-cured product of the resin composition. Here, the expression "include a substrate and a semi-cured product of the resin composition of the embodiment" means that the resin composition that has been subjected to semi-curing (B-staging) with the substrate impregnated with the resin composition is included. In addition, B-staging as used herein indicates that a state of B-staging defined in JIS K6900 (1994) is formed.

The prepreg can be produced by impregnating or coating the substrate with the varnish-like resin composition of the embodiment, followed by heating for drying to perform semi-curing (B-staging) of the resin composition.

As a method for impregnating or coating the substrate with the resin composition, the following hot melt method or solvent method can be adopted.

The holt melt method is (1) a method in which a coated paper having satisfactory release properties against the resin composition is coated with the resin composition into which an organic solvent is not incorporated and laminated on the substrate, or (2) a method in which the substrate is directly coated with the resin composition into which an organic solvent is not incorporated using a die coater.

In contrast, the solvent method is a method in which the substrate is immersed in the resin composition obtained by incorporating an organic solvent into the resin composition, therebye impregnating the substrate with the resin composition, followed by drying.

As the substrate, a fibrous substrate, such as a woven fabric or a nonwoven fabric, is generally used, and a woven fabric is preferred. In addition, the substrate is preferably a sheet-shaped fibrous substrate.

Examples of a material for the fibrous substrate include inorganic fibers, such as glass, alumina, asbestos, boron, silica alumina glass, silica glass, Tyranno, silicon carbide, silicon nitride, and zirconia; organic fibers, such as aramid, a polyether ether ketone, a polyetherimide, a polyethersulfone, carbon, and cellulose; and pulp mixtures thereof. Of these, inorganic fibers are preferred, and glass fibers are more preferred. That is, the substrate is preferably a woven fabric of glass fibers, that is, a glass cloth.

The thickness of the substrate is preferably 5 to 200 µm, and may be 10 to 100 µm or 20 to 50 µm. When the thickness of the substrate is equal to or less than the upper limit value, a dimensional change caused by a temperature change, moisture absorption, or the like in a production process can be decreased.

Although a production condition of the prepreg is not particularly limited, in the case of the solvent method, it is preferable that in the resulting prepreg, the organic solvent used for the resin varnish volatilize to 80% by mass or more.

The drying temperature after the substrate is impregnated or coated with the resin composition is preferably 80 to 180°C, and more preferably 100 to 140°C, and the drying time is appropriately set according to balance between the drying time and the gelation time of the resin composition.

The solids content derived from the resin composition in the prepreg of the embodiment is not particularly limited, but is preferably 30 to 90% by mass, more preferably 35 to 80% by mass, still more preferably 40 to 70% by mass, and particularly preferably 45 to 60% by mass. When the solids content derived from the resin composition in the prepreg is within the above-described range, satisfactory moldability tends to be achieved in forming a laminated plate.

The thickness of the prepreg of the embodiment is not particularly limited, and may be 10 to 200 µm, 10 to 150 µm, or 10 to 100 µm.

### [Laminated Plate and Metal-clad Laminated Plate]

A laminated plate of the embodiment is a laminated plate including a cured product of the resin composition of the embodiment. In addition, the laminated plate of the embodiment may be a laminated plate including a cured product of the prepreg of the embodiment.

A metal-clad laminated plate of the embodiment is a metal-clad laminated plate including a metal foil and a cured product of the resin composition of the embodiment. In addition, the metal-clad laminated plate of the embodiment may be a metal-clad laminated plate including a cured product of the prepreg of the embodiment.

The metal-clad laminated plate can be produced, for example, by superimposing a metal foil on each of adhesive surfaces of both sides of one sheet of the prepreg of the embodiment or both sides of a laminate prepared by laminating two or more (preferably 2 to 20) sheets of the prepreg so as to unite them, and performing molding under heat and pressure at preferably 130 to 260°C, more preferably 180 to 250°C, and still more preferably 210 to 250°C at a pressure of 0.5 to 10 MPa, and preferably 1 to 5 MPa through vacuum pressing.

Examples of the metal foil used for the metal-clad laminated plate include a copper foil, an aluminum foil, a tin foil, a tin-lead alloy (solder) foil, and a nickel foil. In addition, a composite foil of a three-layer structure in which a copper layer of 0.5 to 15 µm and a copper layer of 10 to 300 µm are provided on both surfaces of an intermediate layer made of nickel, a nickel-phosphorus, a nickel-tin alloy, a nickel-iron alloy, lead, a lead-tin alloy, or the like, a composite foil of a two-layer structure in which aluminum and a copper foil are composited, or the like can be used.

The metal foil is preferably a copper foil or an aluminum foil, and more preferably a copper foil.

The thickness of the metal foil may be set to a thickness generally used for laminate plates, and is, for example, 1 to 200 µm.

In the laminated plate and the metal-clad laminated plate of the embodiment, the prepreg (specifically, the resin composition in the prepreg) is C-staged to become a cured product. In other words, the laminated plate of the embodiment may include a C-staged prepreg, and the metal-clad laminated plate of the embodiment may include a C-staged prepreg and a metal foil. Here, C-staging as used herein indicates that a state of C-staging defined in JIS K6900 (1994) is formed.

### [Printed Wiring Board]

A printed wiring board of the embodiment is a printed wiring board including a cured product of the resin composition of the embodiment. In addition, the printed wiring board of the embodiment may include one or more kinds selected from the group consisting of the cured product of the prepreg of the embodiment, the laminated plate of the embodiment, and the metal-clad laminated plate of the embodiment. The printed wiring board of the embodiment may not necessarily include the laminated plate or the metal-clad laminated plate in an unalteread state, and may include, for example, the laminated plate or the metal-clad laminated plate that has been subjected to a circuit-forming process, such as drilling, metal plating, or etching of a metal foil.

The printed wiring board of the embodiment can be produced by performing a circuit-forming process, such as drilling, metal plating, or etching of a metal foil on the laminated plate or the metal-clad laminated plate of the embodiment by a known method, and further performing multilayering, if necessary.

### [Semiconductor Package]

A semiconductor package of the embodiment includes the printed wiring board of the embodiment and a semiconductor element. In other words, the semiconductor package of the embodiment is a semiconductor package including a semiconductor element mounted on the printed wiring board of the embodiment.

The semiconductor package of the embodiment can be produced, for example, by mounting a semiconductor element, such as a semiconductor chip or a memory, at a predetermined position of the printed wiring board of the embodiment by a known method, and sealing the semiconductor element with a sealing resin, or the like.

### Examples

Hereinafter, the embodiment will be described specifically with reference to Examples. However, the embodiment is not limited to the following Examples.

In each example, a weight-average molecular weight (Mw) was measured by the following method.

The weight-average molecular weight was determined from a calibration curve of standard polystyrene by gel permeation chromatography (GPC). The calibration curve was approximated by a cubic equation using standard polystyrene: TSK standard POLYSTYRENE (Type: A-2500, A-5000, F-1, F-2, F-4, F-10, F-20, and F-40) (manufactured by Tosoh Corporation, product name). GPC measurement conditions are as follows.

### Device:

Pump: L-6200 type (manufactured by Hitachi High-Tech Corporation)
Detector: L-3300 type RI (manufactured by Hitachi High-Tech Corporation)
Column oven: L-655A-52 (manufactured by Hitachi High-Tech Corporation)
Column: guard column: "TSK Guardcolumn HHR-L" + column: "TSKgel G4000HHR" + "TSKgel G2000HHR" (all manufactured by Tosho Corporation, product name)
Column size: 6.0×40 mm (guard column), 7.8×300 mm (column)
Eluent: tetrahydrofuran
Sample concentration: 30 mg/5 mL
Injection volume: 20 µL
Flow rate: 1.00 mL/min
Measurement temperature: 40°C

### [Production Example 1: Production of Siloxane-modified Maleimide Compound]

Into a 2 L heating and cooling reactor equipped with a thermometer, a stirrer, and a moisture content measuring device with a reflux condenser, 100 g of both-end diamine-modified siloxane (manufactured by Shin-Etsu Chemical Co., Ltd., product name: X-22-161A, functional equivalent of amino group: 800 g/mol), 450 g of 2,2-bis[4-(4-maleimidophenoxy)phenyl]propane, and 550 g of propylene glycol monomethyl ether were placed, and allowed to react at 120°C for 3 hours to produce a siloxane-modified maleimide compound-containing liquid. The weight-average molecular weight (Mw) of the resultant siloxane-modified maleimide compound was 2,500.

### Examples 1 to 4 and Comparative Examples 1 and 2

### (Preparation of Resin Composition and Resin Varnish)

Components shown in Table 1 were blended in blending amounts shown in Table 1 (the blending amount described in Table 1 refers to parts by mass of solids, and in the case of a solution or dispersion solution, the blending amount refers to parts by mass based on solids), and mixed in methyl isobutyl ketone to obtain a resin composition (resin varnish) having a nonvolatile content (solids concentration) of 50% by mass.

### (Preparation of Prepreg)

With the resin varnish produced in each example, a glass cloth T2118 (manufactured by Nitto Boseki Co., Ltd., product name) was impregnated, and then heated at 120°C for 5 minutes to dry, thereby obtaining a prepreg.

### (Preparation of Double-sided Copper-clad Laminated Plate)

An electrolytic copper foil with a thickness of 12 µm "3EC-M3-VLP-12" (manufactured by Mitsui Mining & Smelting Co., Ltd., product name) was superimposed on both sides of four superimposed sheets of the prepreg so that a matt surface (M surface) faced the prepreg, and the laminate was heated and pressurized at 240°C for 80 minutes under a vacuum pressing condition of 3 MPa to prepare a double-sided copper-clad laminated plate.

### [Evaluation Method]

### (1) Flame Resistance

A flaming combustion time (second) was measured using five specimens in accordance with UL-94, and the average value of the five specimens was determined. The specimens were each prepared by immersing the double-sided copper-clad laminated plate in a copper etchant to remove the copper foil and cutting the laminated plate into a size of 125 mm×13 mm.

### (2) Adhesion Strength to Copper Foil

The copper foil of the double-sided copper-clad laminated plate obtained in each example was partially etched to obtain a specimen having a copper foil line with a width of 3 mm. A load applied during peeling the copper foil line in the 90° direction against the adhesive surface at a rate of 50 mm/min was measured, and the adhesion strength to a copper foil was evaluated. When the load applied during peeling was 0.3 kN/m or more, the adhesive properties to the copper foil were judged to be sufficient.

### (3) Desmear Resistance

The double-sided copper-clad laminated plate obtained in each example was immersed in a copper etchant to prepare a specimen of 40 mm×40 mm without the copper foil.

This specimen was treated with a swelling treatment liquid "Swelling Dip Securiganth P" (manufactured by Atotech Japan K.K.) at 70°C for 5 minutes. Subsequently, the specimen was washed with water at room temperature for 2 minutes and then treated with a roughening liquid "Concentrate Compact CP" (manufactured by Atotech Japan K.K.) at 80°C for 10 minutes or 15 minutes to be roughened. After that, the specimen was washed with water at 50°C for 2 minutes, then subjected to neutralization treatment using a neutralization liquid "Reduction Solution Securiganth P500" (manufactured by Atotech Japan K.K.) at 40°C for 5 minutes, washed with water at room temperature for 5 minutes, and then dried.

The desmear weight reduction amount was calculated from a difference between the dry weight before desmear treatment and the dry weight after the desmear treatment (dry weight before desmear treatment - dry weight after desmear treatment).

In Examples 1 and 2, a percentage based on the desmear weight reduction amount in Comparative Example 1 (100×(desmear weight reduction amount in Example 1 or 2)/(desmear weight reduction amount in Comparative Example 1)) was determined, and in Examples 3 and 4, a percentage based on the desmear weight reduction amount in Comparative Example 2 (100×(desmear weight reduction amount in Example 3 or 4)/(desmear weight reduction amount in Comparative Example 2)) was determined.

### (4) Thermal Expansion Coefficient

The copper foil of each of the both surfaces of the double-sided copper-clad laminated plate obtained in each example was removed by etching to produce a 5 mm square specimen. Subsequently, the thermal expansion coefficient of the specimen was measured with a thermomechanical analyzer (TMA) (manufactured by TA Instruments Japan Inc., product name: Q400) in accordance with IPC (The Institute for Interconnecting and Packaging Electronic Circuits) standards.

More specifically, the measurement was performed twice at a temperature range of 25 to 260°C under conditions of a load of 0.1 N and a temperature increasing rate of 10°C/min, and the average thermal expansion coefficient was determined at the second measurement. The thermal expansion coefficient is a linear thermal expansion coefficient in the plane direction of the specimen.

### [Table 1]

**Table 1**

| | | | | Example | | | | Comparative Example | |
|---|---|---|---|---|---|---|---|---|---|
| | | | | 1 | 2 | 3 | 4 | 1 | 2 |
| Blending composition (part by mass) | Component (A) | Acrylic polymer | Acrylic polymer 1 | 20 | 20 | 15 | 15 | 20 | 15 |
| | Component (B) | Thermosetting resin | Epoxy resin | 10 | 10 | 10 | 10 | 10 | 10 |
| | | | Maleimide compound | 70 | 70 | 75 | 75 | 70 | 75 |
| | Component (C) | Inorganic filler surface-treated with silane coupling agent | Inorganic filler 1 | 150 | 150 | 150 | 150 | 150 | 150 |
| | Component (D) | Silane coupling agent | Vinylsilane-based coupling agent 1 | 0.5 | | | | | |
| | | | Epoxysilane-based coupling agent 1 | | 0.5 | | | | |
| | | | Aminosilane-based coupling agent 1 | | | 0.4 | | | |
| | | | Aminosilane-based coupling agent 2 | | | | 0.2 | | |
| | Component (E) | Curing accelerator | Curing accelerator 1 | 0.5 | 0.5 | 0.5 | 0.5 | 0.5 | 0.5 |
| Evaluation result | (1) Flame resistance (s) | | | 4.1 | 4.1 | 4.5 | 4.3 | 5.4 | 6.1 |
| | (2) Adhesion strength to copper foil (kN/m) | | | 0.4 | 0.4 | 0.4 | 0.4 | 0.4 | 0.4 |
| | (3) Desmear resistance (%) | | | 100 | 100 | 100 | 100 | - | - |
| | (4) Thermal Expansion coefficient (ppm/°C) | | | 4.8 | 5.3 | 5.5 | 5.3 | 5.0 | 5.3 |

Details of the components in the table are as follows.

### [Component (A)]

· Acrylic polymer 1: "TEISANRESIN SG-P3", an acrylic polymer having an epoxy group, weight-average molecular weight: 850,000, epoxy equivalent: 4,800 g/eq (manufactured by Nagase ChemteX Corporation, product name)

### [Component (B)]

· Epoxy resin: "EPICLON HP-9500", a naphthalene skeleton-containing epoxy resin (manufactured by DIC Corporation, product name)
· Maleimide compound: the siloxane-modified maleimide compound produced in Production Example 1

### [Component (C)]

· Inorganic filler 1: a molten spherical silica surface-treated with a phenylsilane-based coupling agent, average particle diameter: 0.5 µm

### [Component (D)]

· Vinylsilane-based coupling agent 1: "KBM-1083" (manufactured by Shin-Etsu Chemical Co., Ltd.)
· Epoxysilane-based coupling agent 1: "KBM-4803" (manufactured by Shin-Etsu Chemical Co., Ltd.)
· Aminosilane-based coupling agent 1: "KBM-6803" (manufactured by Shin-Etsu Chemical Co., Ltd.)
· Aminosilane-based coupling agent 2: "KBM-603" (manufactured by Shin-Etsu Chemical Co., Ltd.)

### [Component (E)]

· Curing accelerator 1: isocyanate-masked imidazole "G-8009L" (manufactured by DKS Co., Ltd., product name)

As apparent from Table 1, the double-sided copper-clad laminated plate in each of Examples using the resin composition of the embodiment exhibited a result in which flame resistance is excellent with satisfactory adhesion strength to a copper foil and desmear resistance maintained although the resin composition contains the component (A) that is relatively combustible. In addition, the double-sided copper-clad laminated plates in Examples had satisfactory low thermal expansion properties.

Meanwhile, the double-sided copper-clad laminated plates in Comparative Examples using a resin composition containing no component (D) had lower flame resistance than those in Examples.

## Claims

1. A resin composition comprising an acrylic polymer (A), a thermosetting resin (B), and an inorganic filler (C) surface-treated with a silane coupling agent, wherein the resin composition further contains a silane coupling agent (D).

2. The resin composition according to claim 1, wherein the component (A) has a weight-average molecular weight (Mw) of 50,000 to 1,500,000.

3. The resin composition according to claim 1, wherein a content of the component (A) is 1 to 50 parts by mass based on 100 parts by mass of a total amount of the components (A) and (B).

4. The resin composition according to claim 1, wherein the component (B) contains at least one kind selected from the group consisting of: an epoxy resin, a polyimide resin, a maleimide compound, a phenol resin, a modified polyphenylene ether resin, a bismaleimide triazine resin, a cyanate resin, an isocyanate resin, a benzoxazine resin, an oxetane resin, an amino resin, an unsaturated polyester resin, an allyl resin, a dicyclopentadiene resin, a silicone resin, a triazine resin, and a melamine resin.

5. The resin composition according to claim 1, wherein the component (B) contains at least one kind selected from the group consisting of a maleimide compound having two or more N-substituted maleimide groups and a derivative thereof.

6. The resin composition according to claim 1, wherein the component (B) contains a siloxane-modified maleimide compound.

7. The resin composition according to claim 1, wherein the component (D) has a functional group capable of reacting with the component (A) or (B).

8. A prepreg comprising a substrate and the resin composition according to any one of claims 1 to 7 or a semi-cured product of the resin composition.

9. A laminated plate comprising a cured product of the resin composition according to any one of claims 1 to 7.

10. A metal-clad laminated plate comprising a metal foil and a cured product of the resin composition according to any one of claims 1 to 7.

11. A printed wiring board comprising a cured product of the resin composition according to any one of claims 1 to 7.

12. A semiconductor package comprising the printed wiring board according to claim 11 and a semiconductor element.
